# EUROPEAN PATENT SPECIFICATION

(11) **EP 2 728 610 B1**
(45) Date of publication and mention of the grant of the patent: **18.03.2020**
(21) Application number: 13191064.8
(22) Date of filing: 31.10.2013
(51) Int. Cl.: H01L 21/20

(54) **METHOD FOR FABRICATING AN EPITAXIAL WAFER**
VERFAHREN ZUR HERSTELLUNG EINES EPITAXIALWAFERS
PROCÉDÉ DE FABRICATION D'UNE TRANCHE ÉPITAXIALE

(30) Priority: 31.10.2012 KR 20120122006; 31.10.2012 KR 20120122004
(43) Date of publication of application: 07.05.2014
(73) Proprietor: LG Innotek Co., Ltd., Seoul, 04637 (KR)
(72) Inventor: Kang, Seok Min, 100-714 SEOUL (KR)
(74) Representative: Novagraaf Technologies

(56) References cited:
- US-A1- 2009 085 044
- US-B2- 7 531 433

## Description

### TECHNICAL FIELD

Embodiments relate to an epitaxial wafer, a method for fabricating the same and a semiconductor device including the same.

### BACKGROUND

Epitaxial growth generally includes a chemical vapor deposition process. In accordance with the epitaxial growth, a wafer is heated while a gas/liquid/solid silicon composite is transferred to a surface of a single crystal silicon wafer (or substrate) to be thermally decomposed or to have an effect on thermal decomposition. At this time, an epitaxial wafer is fabricated by laminating silicon onto a single crystal silicon wafer through continuous growth of a single crystal structure. In this case, defects such as lattice mismatch of aggregated silicon present on wafer surfaces may directly have an effect on quality of epitaxial wafers.

Furthermore, as growth of single crystalline structure continues, defects present on the wafer surface are continuously grown and new crystal defects, *i.e.,* growth defects may be formed on the epitaxial layer. For example, epitaxial stacking defects having a length of about 0.1 µm to about 10 µm and surface defects such as hillock may be formed on wafers.

US 7 531 433 B2 , column 8, lines 12-27 figures 8 discloses homoepitaxy of low defect density SiC layers on less than 1 degree off-cut substrates. and use of a buffer layer ("boundary layer") grown at a lower growth rate or (hence also "and") at higher growth temperature than the subsequent layer.

US 2009/085044 A1, figure 8 discloses a "dislocation conversion layer" 82 intermediate between SiC substrate 81 and SiC epilayer 83 which allows conversion of a large number of basal plane dislocations into threading edge dislocations. The dislocation conversion layer features a donor concentration lower than that of the drift layer.

EP 1 215 730 A1 , figure 1, 3, 5, 6 and paragraph [0095]
discloses a process for homoepitaxy of SiC on SiC using a buffer layer.

### SUMMARY

Embodiments provide a method for fabricating an epitaxial wafer according to the attached claims.

### BRIEF DESCRIPTION OF THE DRAWINGS

Arrangements and embodiments will be described in detail with reference to the following drawings in which like reference numerals refer to like elements and wherein:
FIGs. 1A to 1C are sectional views illustrating a method for fabricating an epitaxial wafer according to an embodiment;
FIG. 2 is a flowchart illustrating the method for fabricating an epitaxial wafer according to the present embodiment;
FIG. 3 is a graph showing an example of growth conditions of the method shown in FIG. 2;
FIG. 4 is a graph showing another example of growth conditions of the method shown in FIG. 2;
FIG. 5 is a sectional view schematically illustrating an epitaxial wafer according to the present embodiment.
FIG. 6A to 6C are sectional views illustrating a method for fabricating an epitaxial wafer according to another embodiment;
FIG. 7 is a flowchart illustrating the method for fabricating an epitaxial wafer according to another embodiment;
FIG. 8 is a graph illustrating an example of growth conditions associated with the method shown in FIG. 7; and
FIG. 9 is a sectional view schematically illustrating an epitaxial wafer according to another embodiment.

### DESCRIPTION OF SPECIFIC EMBODIMENTS

Reference will now be made in detail to the preferred embodiments, examples of which are illustrated in the accompanying drawings. The disclosure should not be construed as limited to the embodiments set forth herein and includes modifications, variations, equivalents, and substitutions compliant with the spirit and scope of the disclosure defined by the appended claims.

Detailed descriptions of well-known functions or configurations related to the disclosure may be omitted if they are considered to obscure the subject matter of the disclosure. In addition, ordinal numerals (for example, first or second) used for the description of the disclosure are only used as discernment symbols to distinguish one element from another element.

The surface defect density of the epitaxial wafer including an epitaxial layer grown on the substrate (or wafer) may be changed according to parameters such as flux of initial reactive gas, growth temperature, pressure, total flux, C/Si ratio and Si/H₂ ratio.

In accordance with the embodiment, in order to reduce the surface defect density of the epitaxial wafer to 0.5 or less per cm², that is, to 0.5 or less per 1 cm², at least one of growth temperature, growth speed (that is, flux of injected reactive gas), thickness of epitaxial layer to be preliminarily grown, or C/Si ratio may be controlled. For example, the size of surface defect to be reduced may be several µm² to several tens of µm², but the embodiment is not limited thereto.

Hereinafter, a method 200A for fabricating an epitaxial wafer according to an embodiment and an epitaxial wafer 300A fabricated by the method will be described with reference to the annexed drawings below.

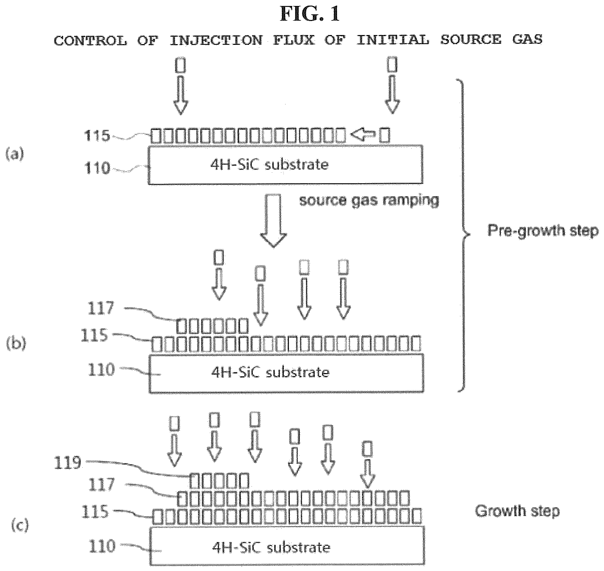

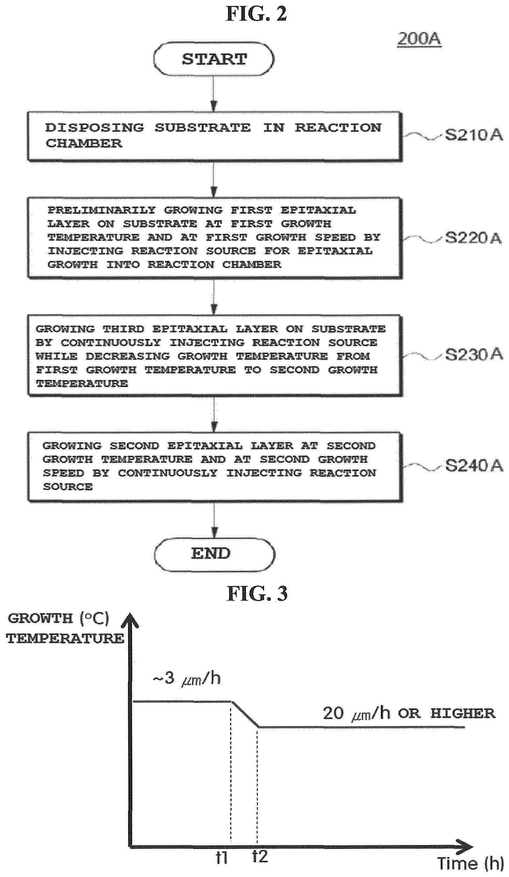

FIGs. 1A to 1C are sectional views illustrating the method 200A for fabricating an epitaxial wafer according to the embodiment. FIG. 2 is a flowchart illustrating the method 200A for fabricating an epitaxial wafer according to the embodiment.

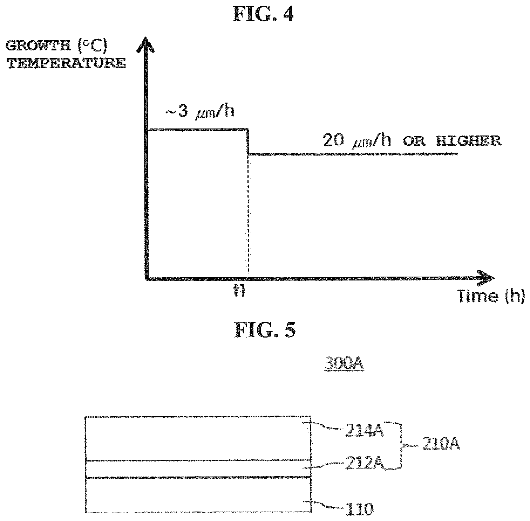

FIG. 3 is a graph showing an example of growth conditions of the method 200A shown in FIG. 2. FIG. 4 is a graph showing another example of growth conditions of the method 200A shown in FIG. 2. In the respective graphs, an x-axis represents time and a y-axis represents a growth temperature.

Hereinafter, the method 200A for fabricating an epitaxial wafer exemplarily shown in FIG. 2 will be described with reference to FIGs. 1A to 1C, but the embodiment is not limited to the sectional views shown in FIGs. 1A to 1C.

In accordance with the method 200A for fabricating an epitaxial wafer according to the embodiment, first, a substrate 110 is disposed in a reaction chamber (not shown) (step 210A), as exemplarily shown in FIG. 1A. Here, the substrate 110 may be a semiconductor substrate and is for example a silicon carbide-based substrate. In addition, FIGs. 1A to 1C shows a case in which the substrate 110 is a 4H-SiC substrate, but the embodiment is not limited thereto. That is, other substrate such as 6H-SiC, 3C-SiC or 15R-SiC, in addition to the 4H-SiC substrate 110, may be used according to types of elements or products to finally be disposed on the epitaxial wafer according to the embodiment.

After the step S210A, a pre-growth step S220A is performed.

When a laminate layer (not shown) is formed by laminating or growing a material made of a certain substance on the substrate 110, it may be difficult to secure reliability of the laminate layer due to lattice constant mismatch between the substrate 110 and the laminate layer. In order to solve this problem, as exemplarily shown in FIG. 1A, the epitaxial layer may be laminated as a buffer layer 115 on the substrate 110. However, when defects are generated on the surface of the buffer layer 115 in the process of growing the buffer layer 115 and thus a surface defect density is higher than a tolerance, for example, 1 per cm², the epitaxial wafer is unsuitable for use in products. Accordingly, in accordance with the embodiment, in order to decrease the surface defect density to 0.5 or less per cm², the buffer layer 115 is formed on the substrate 110 and a pre-growth step S220A is then performed thereon to form the first epitaxial layer 117 on the buffer layer 115, as exemplarily shown in FIG. 1B.

The pre-growth step S220A may be performed at a first growth temperature and at a first growth speed. The first growth temperature may be higher than a second growth temperature of a growth step S240A described later. In addition, the first growth speed may be lower than the second growth speed of the growth sped S240A.

That is, the pre-growth step S220A is a process of growing the first epitaxial layer 117 on the substrate 110 at the first growth temperature higher than the second growth temperature and at the first growth speed lower than the second growth speed while injecting a reaction source for epitaxial growth into reaction chamber, as shown in FIG. 1B. The reaction source may be changed according to material and type of the substrate 110 on which the first epitaxial layer 117 is laminated. For example, in the case in which the substrate 110 is a silicon carbide-based substrate, as exemplarily shown in FIGs. 1A to 1C, a liquid, vapor or solid substance containing carbon and silicon such as SiH₄+C₃H₈+H₂, MTS (CH₃SiCl₃), TCS (SiHCl₃), SiₓCₓ (in which x is a positive integer of 1 or more) or SiₓC_{y} (in which respective x and y are independently positive integers of 1 or more) which is a material which matches in lattice constant with the substrate 110 may be used as the reaction source.

In the case in which the first and second epitaxial layers 117 and 119 to be laminated on the substrate 110 through the epitaxial growth process described above are doped with an n-type dopant, a Group V element such as nitrogen (N₂) gas may be used as the source gas.

In accordance with the embodiment, the first growth temperature of the pre-growth step S220A may be for example 10°C to 300°Chigher than the second growth temperature of the growth step S240A. In addition, the first growth speed may be set for example to a speed of 3 µm/h or less, that is, a speed at which the epitaxial layer 117 is laminated to a thickness of 3 µm or less per hour, as exemplarily shown in FIG. 3 or 4. Here, the first growth speed may be controlled by controlling the flux of the reaction source injected into the chamber.

When epitaxial growth is performed at a high growth temperature, mobility between atoms contained in the reaction source is high due to high energy of the atoms. Accordingly, when the epitaxial layer is grown on the substrate 110 at a considerably high speed while maintaining a high growth temperature, it may be difficult to uniformly laminate or grow the epitaxial layer on the substrate 110. In consideration of this fact, in the pre-growth step S220A according to the present embodiment, mobility between atoms contained in the reaction source is high and an environment enabling even growth is thus provided by maintaining the high first growth temperature, and time enabling the atoms to be uniformly distributed and grown on the substrate 110 can be secured by reducing the first growth speed.

Accordingly, because the first epitaxial layer 117 is grown on the substrate 110 through the pre-growth step S220A before the second epitaxial layer 119 is grown through the growth step S240A, lattice mismatch between the substrate 110 and the second epitaxial layer 119 is reduced and surface defects of the second epitaxial layer 119 are thus considerably reduced.

Accordingly, the pre-growth step S220A is a preliminary process which reduces surface defects caused by lattice mismatch in an early growth stage and thereby aids the growth step S240A. Accordingly, the thickness of the first epitaxial layer 117 grown by the pre-growth step S220A may be about 1.0 µm or less, for example, from 0.5 µm to 1.0 µm. Here, the thicknesses of the first epitaxial layer 117 grown through the pre-growth step S220A may be changed by controlling the growth time (0 to t1) exemplarily shown in FIGs. 3 and 4 as well as the first growth temperature and the first growth speed.

After the pre-growth step for growing the buffer layer 115 and the first epitaxial layer 117 is performed as shown in FIGs. 1A and 1B above, the subsequent growth step corresponding to a Growth step as shown in FIG. 1C is performed (S240A). Here, the growth step S240A is a process of forming a second epitaxial layer 119 through full epitaxial growth on the first epitaxial layer 117 grown based on the pre-growth step S220A. The growth step S240A may enable epitaxial growth at the second growth speed considerably higher than the first growth speed of the pre-growth step S220A as the growth step S240A is performed after the pre-growth step S220A. For example, the growth step S240A may be performed at a speed of 20 µm/h or higher, as exemplarily shown in FIG. 3 or 4.

In addition, when the second growth temperature of the growth step S240A is lower than 1,500°C, surface defects may be caused. When the second growth temperature is higher than 1,650°C, growth of the second epitaxial layer 119 may be difficult. Accordingly, the second growth temperature may be for example set within 1,500°C to 1,650°C.

The growth step S240A may be performed until a desired thickness of the second epitaxial layer 119 is obtained. For example, the growth step S240A may be performed until thicknesses of the first and second epitaxial layers 117 and 119 formed on the substrate 110 reach target thicknesses. The target thicknesses may be changed according to at least one of utilization purpose of epitaxial wafers, application of epitaxial wafers, features of final elements or products, or design specifications of final elements or products.

When the ratio of carbon to silicon (C/Si) is less than 0.7 during growth of the first epitaxial layer 117 during the pre-growth step S220A under the growth conditions described above, adjacent devices may be damaged by silicon particles. In addition, when the ratio (C/Si) is higher than 1, it may be difficult to dope epitaxial wafers to a desired level. Accordingly, the ratio (C/Si) in the pre-growth step S220A may be 0.7 to 1.

In addition, the ratio (C/Si) upon growth of the second epitaxial layer 119 during the growth step S240A may be set to 1 or more, but the embodiment is not limited thereto.

The growth step S240A and the pre-growth step S220A may continuously be performed without intermission. The continuous performance of the growth step S240A and the pre-growth step S220A may be carried out by the following methods.

In accordance with an embodiment not forming part of the invention, the growth step S240A may be performed immediately after the pre-growth step S220A while not stopping injection of the same reaction source (while not stopping the growth step). That is, as exemplarily shown in FIG. 4, the growth step S240A may be performed under different process conditions immediately after the pre-growth step S220A is performed for a period of 0 to t1. In this case, the step S230A as exemplarily shown in FIG. 2 may be omitted.

In another embodiment, as exemplarily shown in FIG. 2, after the pre-growth step S220A and before the growth step S240A, an intermediate growth step S230A of forming a third epitaxial layer (not shown) on the first epitaxial layer 117 with continuously injecting a reactive gas may be performed.

As exemplarily shown in FIG. 3, the intermediate growth step S230A may be performed for a period of t1 to t2.

The intermediate growth step S230A may be performed at a growth temperature which decreases linearly (proportionally) from the first growth temperature of the pre-growth step S220A to the second growth temperature of the growth step S240A. The intermediate growth step S230A may be performed at a growth temperature which decreases linearly (proportionally) from the first growth temperature to the second growth temperature and at a growth speed which increases linearly (proportionally) from the first growth speed to the second growth speed.

Although not shown, the decrease in growth temperature and the increase in growth speed during the intermediate growth step S230A may be changed nonlinearly. For example, the growth temperature of the intermediate growth step S230A may decrease stepwise from the first growth temperature to the second growth temperature or increase stepwise from the first growth speed to the second growth speed.

FIG. 5 is a sectional view schematically illustrating an epitaxial wafer 300A according to the embodiment.

The epitaxial wafer 300A according to the embodiment includes a substrate (or wafer) 110 and an epitaxial structure 210A disposed on the substrate 110. The substrate 110 may be a semiconductor substrate and may be for example a silicon carbide-based substrate. The substrate 110 may correspond to the substrate 110 exemplarily shown in FIGs. 1A to 1C.

When the substrate 110 is a silicon carbide-based substrate, the epitaxial structure 210A may also be a silicon carbide structure. That is, each of the substrate 110 and the epitaxial structure 210A may include silicon carbide.

Specifically, the epitaxial structure 210A includes first and second epitaxial layers 212A and 214A. The first epitaxial layer 212A is formed on the substrate 110 and the second epitaxial layer 214A is formed on the first epitaxial layer 212A. The first and second epitaxial layers 212A and 214A may correspond to the first and second epitaxial layers 117 and 119 exemplarily shown in FIGs. 1B and 1C, respectively. In the case of the epitaxial wafer 300A shown in FIG. 5, the buffer layer 115 shown in FIG. 1A is omitted. The epitaxial wafer 300A according to the embodiment may not include the buffer layer 115.

The first epitaxial layer 212A may be formed on the substrate 110 through the pre-growth step S220A exemplarily shown in FIG. 2. As such, the first epitaxial layer 212A between the substrate 110 and the second epitaxial layer 214A is disposed so that leakage current caused when voltage is applied to the epitaxial wafer 300A may be suppressed. In this case, the first epitaxial layer 212A may have a thickness of 1 µm or less, for example, 0.5 µm to 1.0 µm.

The second epitaxial layer 214A may be formed to the target thickness through the growth step S240A described above and have a surface defect density of 0.5 or less per cm² because it is formed on the first epitaxial layer 212A. The second epitaxial layer 214A is grown at the second growth speed higher than the first growth speed of the first epitaxial layer 212A.

Both the first epitaxial layer 212A and the second epitaxial layer 214A may be formed of n-type conductive silicon carbide. When the substrate 110 is implemented by silicon carbide (SiC), both the first epitaxial layer 212A and the second epitaxial layer 214A may include silicon carbon nitride (SiCN).

However, the embodiment is not limited to materials of the first epitaxial layer 212A and the second epitaxial layer 214A. Alternatively, both the first epitaxial layer 212A and the second epitaxial layer 214A may include p-type conductive silicon carbide. In this case, each of the first epitaxial layer 212A and the second epitaxial layer 214A may be formed of aluminum silicon carbide (AlSiC).

In accordance with the method 200A for fabricating the epitaxial layer described above, the first epitaxial layer 212A and the second epitaxial layer 214A may have the same composition because the pre-growth step S220A and the growth step S240A are continuously performed without stopping injection of the same reaction source.

FIG. 5 is a sectional view of the epitaxial wafer 300A fabricated by the method 200A shown in FIG. 2 with omitting an intermediate growth step S230A, as exemplarily shown in FIG. 4.

However, when the intermediate growth step S230A is performed as exemplarily shown in FIG. 3, the epitaxial wafer 300A exemplarily shown in FIG. 5 may further include a third epitaxial layer (not shown) disposed between the first epitaxial layer 212 and the second epitaxial layer 214.

Hereinafter, a method 200B for fabricating an epitaxial wafer according to another embodiment and an epitaxial wafer 300B fabricated by the method 200B will be described with reference to the annexed drawings.

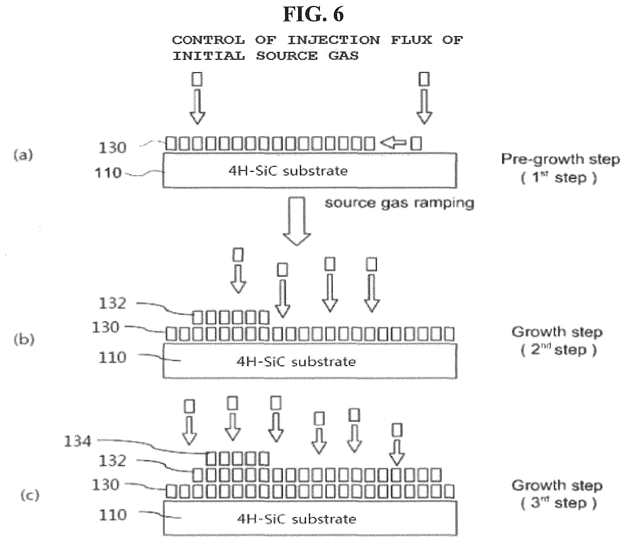

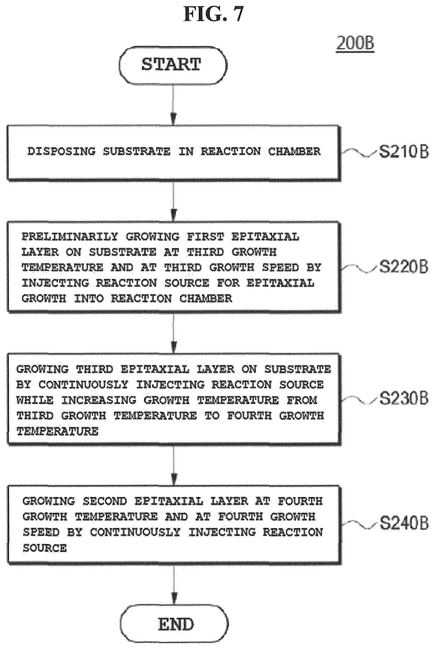

FIG. 6A to 6C are sectional views illustrating the method 200B for fabricating an epitaxial wafer according to another embodiment and FIG. 7 is a flowchart illustrating the method 200B for fabricating an epitaxial wafer according to another embodiment.

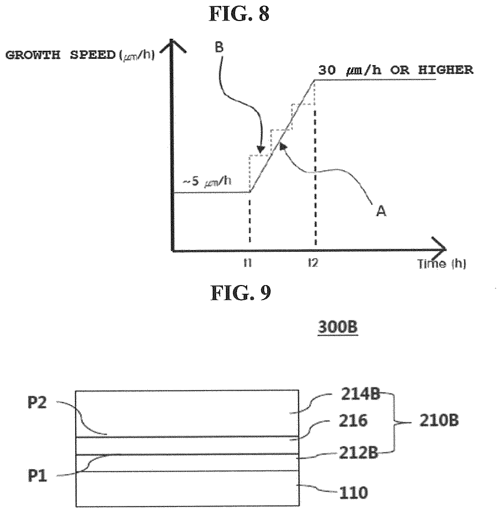

FIG. 8 is a graph illustrating an example of growth conditions associated with the method 200B shown in FIG. 7. An x-axis represents time and a y-axis represents growth speed.

The method 200B for fabricating an epitaxial wafer exemplarily shown in FIG. 7 will be described with reference to FIGs. 6A to 6C, but the embodiment is not limited to the sectional views shown in FIGs. 6A to 6C.

Hereinafter, only different features between the method 200B for fabricating an epitaxial wafer exemplarily shown in FIG. 7 and the method 200A for fabricating an epitaxial wafer shown in FIG. 2 are described and the same features are not repeatedly described.

In accordance with the method 200B for fabricating an epitaxial wafer according to another embodiment, first, as exemplarily shown in FIG. 6A, a substrate 110 is disposed in a reaction chamber (S210B). The substrate 110 exemplarily shown FIGs. 6A to 6C may be the same as the substrate 110 exemplarily shown in FIGs. 1A to 1C and a repeated description is omitted.

After the step S210B, a pre-growth step S220B is performed.

When a laminate layer (not shown) is formed on the substrate 110, it may be difficult to secure reliability of the laminate layer due to lattice constant mismatch between the substrate 110 and the laminate layer. In order to solve this problem, the epitaxial layer may be laminated as a buffer layer on the substrate 110. However, when defects are generated on the surface of the buffer layer in the process of growing the buffer layer so that a surface defect density is above an acceptable range, for example, 1/cm², the epitaxial wafer may be unsuitable for use in products. Accordingly, in accordance with the embodiment, in order to decrease the surface defect density to 0.5 defects or less per cm², the buffer layer is formed on the substrate 110 and a pre-growth step S220B is then performed thereon to form the first epitaxial layer on the buffer layer. For example, the buffer layer and the first epitaxial layer are formed on the substrate 110 in the "pre-growth step (1^{st} step)" shown in FIG. 6A. In FIG. 6A, the reference numeral "130" represents both the buffer layer and the first epitaxial layer, but hereinafter the reference numeral "130" represents the first epitaxial layer for convenience of description.

Next, referring to FIG. 6A, in the pre-growth step S220B, a reaction source is injected onto substrate 110 to form a first epitaxial layer 130 at a third growth temperature and at a third growth speed. Here, the reaction source may be the same as or different from the reaction source used in the process exemplarily shown in FIGs. 1A to 1C. That is, the reaction source may be changed according to material or type of the substrate 110 on which the first epitaxial layer 130 is laminated. In the case in which the substrate 110 is a silicon carbide-based substrate, as exemplarily shown in FIGs. 6A to 6C, a liquid, vapor or solid substance containing carbon and silicon such as SiH₄+C₃H₈+H₂, MTS (CH₃SiCl₃), TCS (SiHCl₃), SiₓCₓ (in which x is a positive integer of 1 or more), or SiₓC_{y} (in which respective x and y are positive integers of 1 or more) which is a material which matches in lattice constant with the substrate 110 may be used as the reaction source.

Unlike the pre-growth step S220A shown in FIG. 2, the third growth temperature is lower than a fourth growth temperature of the growth step S240B later described. For example, when the fourth growth temperature of the growth step S240B is lower than 1,500°C, surface defects may be caused. When the fourth growth temperature is higher than 1,700°C, growth cf the second epitaxial layer 134 exemplarily shown in FIG. 6C may be difficult. Accordingly, the fourth growth temperature is for example 1,500°C to 1,700°C. In this case, the third growth temperature may be set within 1,400 °C to 1,500 ° C.

In addition, the third growth speed of the pre-growth step S220B may be lower than the fourth growth speed of the growth step S240B. For example, the third growth speed may be for example set to a speed of 5 µm/h or less (that is, the speed at which the first epitaxial layer 130 is laminated to a thickness of 5 µm or less per hour). Like the aforementioned first growth speed, the third growth speed may be controlled by controlling the flux of the reaction source injected into the chamber.

When epitaxial growth is performed at a high growth speed, uniform growth of the epitaxial layer may be generally difficult. Accordingly, in accordance with the present embodiment, mobility between atoms contained in the reaction source is high and an environment enabling even growth is thus provided by maintaining the third growth temperature of the pre-growth step S220B and a time enabling the atoms to be uniformly distributed and grown on the substrate 110 may be secured by reducing the third growth speed. Accordingly, because the first epitaxial layer 130 is grown on the substrate 110 through the pre-growth step 220B before the second epitaxial layer 134 is grown through the growth step S240B, lattice mismatch between the substrate 110 and the second epitaxial layer 134 is reduced and surface defects of the second epitaxial layer 134 is thus considerably reduced.

The pre-growth step S220B is a preliminary process which reduces surface defects caused by lattice mismatch in an early growth stage and thereby aids the growth step S240B. Accordingly, the thickness of the first epitaxial layer 130 grown by the pre-growth step S220B may be about 1.0 µm or less, for example, from 0.5 µm to 1.0 µm.

In addition, a thickness of the first epitaxial layer 130 grown through the pre-growth step S220B may be changed by controlling growth period (0 to t1) exemplarily shown in FIG. 8 as well as the third growth temperature and the third growth speed.

After the pre-growth step S220B and before the growth step S240B, an intermediate growth step S230B corresponding to the growth step (2^{nd} step) shown in FIG. 6B is performed for the period of t1 to t2 shown in FIG. 8, to form a third epitaxial layer 132.

As the growth step S240B is a process of performing epitaxial growth on the first epitaxial layer 130 grown based on the pre-growth step S220B, an intermediate growth step S230B serving as a medium naturally connecting the pre-growth step S220B to the growth step S240B is performed.

Accordingly, in accordance with the method 200B for fabricating an epitaxial wafer according to the embodiment, the growth step S240B and the pre-growth step S220B may be continuously performed without intermission via the intermediate growth step S230B. That is, the overall process from the pre-growth step S220B to the growth step S240B may be continuously performed without stopping injection of the reaction source (without stopping the growth step) by performing the intermediate growth step S230B. The intermediate growth step S230B enabling the continuous process from the pre-growth step S220B to the growth step S240B may be carried out by the following various methods.

In an embodiment, as represented by "A" in FIG. 8, the intermediate growth step S230B may be performed at a growth speed which gradually increases linearly (proportionally) from the third growth speed of the pre-growth step S220B to the fourth growth speed of the growth step S240B. The linear increase of the growth speed may be carried out by continuously injecting the reaction source with increasing an amount of the reaction source. The intermediate growth step S230B may be performed at a growth temperature which increases linearly (proportionally) from the third growth temperature to the fourth growth temperature, in addition to, at the growth speed increasing linearly.

In another embodiment, the intermediate growth step S230B may be performed at a growth speed which increases nonlinearly from the third growth speed of the pre-growth step S220B to the fourth growth speed of the growth step S240B. For example, as represented by "B" in FIG. 8, the intermediate growth step S230B may be performed at a growth speed which increases stepwise from the third growth speed of the pre-growth step S220B to fourth growth speed of the growth step S240B. The stepwise increase of the growth speed may be carried out by continuously injecting the reaction source while intermittently increasing a flux of injected reaction source at an interval of time. The intermediate growth step S230B may be performed at a growth temperature which increases nonlinearly (proportionally) from the third growth temperature to the fourth growth temperature, in addition to, at the growth speed increasing nonlinearly. For example, the intermediate growth step S230B may be performed at a growth temperature which stepwise increases from the third growth temperature to the fourth growth temperature.

As described above, the intermediate growth step S230B according to the present embodiment may be a step of growing the third epitaxial layer 132 by injecting the reaction source onto the substrate 110 while gradually increasing a growth speed from the third growth speed of the pre-growth step S220B to the fourth growth speed of the growth step S240B.

After the intermediate growth step S230B, a growth step corresponding to "growth step (3^{rd} step)" shown in FIG. 6C is performed (S240B). The growth step S240B is a process of forming the second epitaxial layer 134 on the third epitaxial layer 132 by predominantly performing epitaxial growth on the third epitaxial layer 132 grown based on the intermediate growth step S230B. The growth step S240B may enable epitaxial growth at a fourth growth speed much higher than the third growth speed of the pre-growth step S220B, because it is a growth step after the pre-growth step S220B and the intermediate growth step S230B. For example, the growth step S240B may be performed at a speed of 30 µm/h or higher as exemplarily shown in FIG. 8.

Like the growth step S240A shown in FIG. 2, the growth step S240B may be performed until a desired thickness of the second epitaxial layer 134 is obtained. For example, the growth step S240B may be performed until thicknesses of the first, second and third epitaxial layers 130, 134 and 132 formed on the substrate 110 reach the target thicknesses. At this time, the target thicknesses may be changed according to at least one of utilization purpose of epitaxial wafers, application of epitaxial wafers, features of final elements or products, or design specifications of final elements or products.

In the methods 200A and 200B for fabricating an epitaxial wafer according to the embodiments described above, the growth steps S240A and S240B may be continuously performed without intermission after the pre-growth steps S220A and S220B. In particular, in the methods 200A and 200B for fabricating an epitaxial wafer, the intermediate growth steps S230A and S230B serve as media naturally connecting the pre-growth step S220A and S220B to the growth steps S240A and S240B, thus enabling the growth steps S240A and S240B to be continuously performed without intermission after the pre-growth steps S220A and S220B. Accordingly, the epitaxial wafer fabricated by the method according to the present embodiment has a low surface defect density and considerably reduced fabrication time and cost of the epitaxial wafer, as compared to epitaxial wafers fabricated by a conventional method for fabricating epitaxial wafers.

The conventional method includes growing the epitaxial layer at a low growth speed of about 8 µm/h to about 10 µm/h in order to solve the surface defect density problem, because it does not include the pre-growth steps S220A and S220B according to the embodiments. Furthermore, the conventional method for fabricating an epitaxial wafer involves a complicate process including excessively growing an epitaxial layer to a thickness of 50 µm and then polishing the epitaxial layer until a target thickness of the epitaxial layer is obtained. However, the methods 200A and 200B for fabricating an epitaxial wafer according to the embodiments solve the surface defect density problem through the pre-growth steps S220A and S220B, thus realizing growth at a considerably high second growth speed (or fourth growth speed) of the growth steps S240A and S240B. Also, the methods according to the embodiments do not require any separate polishing process, thus greatly reducing overall process time and cost.

FIG. 9 is a sectional view schematically illustrating an epitaxial wafer 300B according to another embodiment.

Unlike the epitaxial wafer 300A exemplarily shown in FIG. 5, the epitaxial structure 210B of the epitaxial wafer 300B exemplarily shown in FIG. 9 may further include the third epitaxial layer 216 disposed between the first and second epitaxial layers 212B and 214B as well as the first and second epitaxial layers 212B and 214B. Apart from this feature, the epitaxial structure 210B exemplarily shown in FIG. 9 may be the same as the epitaxial structure 210A exemplarily shown in FIG. 5.

The epitaxial wafer 300B includes a substrate 110 and an epitaxial structure 210B disposed on the substrate 110. The substrate 110 may correspond to the substrate 110 exemplarily shown in FIGs. 6A to 6C. The substrate 110 may be a semiconductor substrate and may be, for example, a silicon carbide-based substrate. When the substrate 110 is a silicon carbide-based substrate, the epitaxial structure 210B may be also a silicon carbide structure. That is, each of the substrate 110 and the epitaxial structure 210B may include silicon carbide.

The first epitaxial layer 212B may be formed on the substrate 110 through the pre-growth step S220B described above. As such, the first epitaxial layer 212B disposed between the substrate 110 and the second epitaxial layer 214B is disposed so that leakage current caused when voltage is applied to the epitaxial wafer 300B may be suppressed. In this case, the first epitaxial layer 212B may have a thickness of 1 µm or less. The first epitaxial layer 212B may correspond to the first epitaxial layer 130 shown in FIG. 6A.

The second epitaxial layer 214B may be formed to the target thickness through the growth step S240B described above and have a surface defect density of 0.5 or less per cm². The second epitaxial layer 214B may correspond to the second epitaxial layer 134 as shown in FIG. 6C.

In addition, the third epitaxial layer 216 is formed between the first epitaxial layer 212B and the second epitaxial layer 214B. The third epitaxial layer 216 may be formed on the first epitaxial layer 212B through the aforementioned intermediate growth step S230B and may correspond to the third epitaxial layer 132 shown in FIG. 6B.

In addition, the third epitaxial layer 216 may have a first doping concentration in a first boundary (plane) P1 between the third epitaxial layer 216 and the first epitaxial layer 212B and may have a second doping concentration in a second boundary (plane) P2 between the third epitaxial layer 216 and the second epitaxial layer 214B. Here, the first boundary P1 may mean a lower surface or region of the third epitaxial layer 216 adjacent to the first epitaxial layer 212B, and the second boundary P2 may mean an upper surface or region of the third epitaxial layer 216 adjacent to the second epitaxial layer 214B.

Here, the first doping concentration may be different from the second doping concentration. For example, the first doping concentration may be 5x10¹⁷ atoms/cm² to 1×10¹⁸ atoms/ cm².

In an example, when the growth speed increases linearly or nonlinearly (or, stepwise) from the third growth speed of the pre-growth step S220B to the fourth growth speed of the growth step S240B, reaction time with the doping gas is reduced. Accordingly, an inner doping concentration between the first boundary P1 and the second boundary P2 of the third epitaxial layer 216 may gradually decrease linearly or nonlinearly from the first boundary P1 to the second boundary P2, but the embodiment is not limited thereto.

In another example, when the growth speed is reversely controlled, an inner doping concentration between the first boundary P1 and the second boundary P2 of the third epitaxial layer 216 may gradually increase linearly or nonlinearly from the first boundary P1 to the second boundary P2.

All the first to third epitaxial layers 212B, 214B and 216 may be formed of n-type conductive silicon carbide. That is, when the substrate 110 includes silicon carbide (SiC), the respective first to third epitaxial layers 212B, 214B and 216 may include silicon carbon nitride (SiCN), but the embodiment is not limited thereto. That is, when the first to third epitaxial layers 212B, 214B and 216 are formed of p-type conductive silicon carbide, the respective first to third epitaxial layers 212B, 214B and 216 may include aluminum silicon carbide (AlSiC).

The epitaxial wafers 300A and 300B described above may be applied to metal semiconductor field effect transistors (MESFETs). For example, the metal semiconductor field effect transistor (MESFET) is fabricated by forming an ohmic contact layer including a source and drain on the second epitaxial layers 214A and 214B according to the present embodiment. Furthermore, the epitaxial wafers 300A and 300B according to the embodiments may be applied to various semiconductor devices.

Accordingly, the epitaxial wafers 300A and 300B may have reduced surface defect density and thus improved properties to be high quality, and the methods 200A and 200B for fabricating epitaxial wafers may enable fabrication of epitaxial wafers with reduced surface defect density and enhanced yield.

Although embodiments have been described with reference to a number of illustrative embodiments thereof, it should be understood that numerous other modifications and embodiments can be devised by those skilled in the art.

## Claims

1. A method for fabricating an epitaxial wafer (300B), wherein the method comprises:
forming a buffer layer on a substrate (110) including silicon carbide; growing a first epitaxial layer (212B) having a thickness of 1 µm or less on the buffer layer at a first growth temperature that is set within 1400°C and 1500°C and at a first growth speed that is set to a speed of 5 µm/h or less, by injecting a reaction source onto the substrate (110);
growing a second epitaxial layer (214B) at a second growth temperature that is set within 1500°C to 1700°C and at a second growth speed that is set to a speed of 30 µm/h or higher by continuously injecting the reaction source onto the substrate,
the method further comprising growing a third epitaxial layer (216) on the first epitaxial layer (212B) by continuously injecting the reaction source after the growing of the first epitaxial layer (212B) and before the growing of the second epitaxial layer (214B), at a growth temperature which changes linearly or stepwise from the first growth temperature to the second growth temperature,
wherein each of the substrate and the epitaxial structure comprises silicon carbide.

2. The method according to claim 1, wherein a composition of the first epitaxial layer is the same as that of the second epitaxial layer.

3. The method according to any of claims 1 and 2, wherein each of the first and second epitaxial layers doped with an n-type dopant comprises silicon carbon nitride, SiCN.

4. The method according to any of claims 1 and 2, wherein each of the first and second epitaxial layers doped with a p-type dopant comprises aluminum silicon carbide, AlSiC.

5. The method according to any of claims 1 to 4, wherein the first epitaxial layer has a thickness of 0.5 µm to 1.0 µm.

## Patentansprüche

1. Verfahren zur Herstellung eines epitaktischen Wafers (300B), wobei das Verfahren umfasst:
Bilden einer Pufferschicht auf einem Substrat (110), das Siliciumcarbid einschließt;
Aufwachsen einer ersten epitaktischen Schicht (212B), die eine Dicke von 1 µm oder weniger aufweist, auf der Pufferschicht bei einer ersten Wachstumstemperatur, die innerhalb 1400 °C und 1500 °C eingestellt ist, und bei einer ersten Wachstumsgeschwindigkeit, die auf eine Geschwindigkeit von 5 µm/h oder weniger eingestellt ist, durch Injizieren einer Reaktionsquelle auf das Substrat (110);
Aufwachsen einer zweiten epitaktischen Schicht (214B) bei einer zweiten Wachstumstemperatur, die innerhalb 1500 °C bis 1700 °C eingestellt ist, und bei einer zweiten Wachstumsgeschwindigkeit, die auf eine Geschwindigkeit von 30 µm/h oder höher eingestellt ist, durch kontinuierliches Injizieren der Reaktionsquelle auf das Substrat,
wobei das Verfahren weiter das Aufwachsen einer dritten epitaktischen Schicht (216) auf der ersten epitaktischen Schicht (212B) durch kontinuierliches Injizieren der Reaktionsquelle nach dem Aufwachsen der ersten epitaktischen Schicht (212B) und vor dem Aufwachsen der zweiten epitaktischen Schicht (214B) bei einer Wachstumstemperatur umfasst, die sich linear oder schrittweise von der ersten Wachstumstemperatur zur zweiten Wachstumstemperatur verändert,
wobei jedes aus dem Substrat und der epitaktischen Struktur Siliciumcarbid umfasst.

2. Verfahren nach Anspruch 1, wobei eine Zusammensetzung der ersten epitaktischen Schicht dieselbe ist wie jene der zweiten epitaktischen Schicht.

3. Verfahren nach einem der Ansprüche 1 und 2, wobei jede aus der ersten und zweiten epitaktischen Schicht, die mit einem n-Typ-Dotierstoff dotiert wird, Silicium-Kohlenstoff-Nitrid, SiCN, umfasst.

4. Verfahren nach einem der Ansprüche 1 und 2, wobei jede aus der ersten und zweiten epitaktischen Schicht, die mit einem p-Typ-Dotierstoff dotiert wird, Aluminium-Silicium-Carbid, AlSiC, umfasst.

5. Verfahren nach einem der Ansprüche 1 bis 4, wobei die erste epitaktische Schicht eine Dicke von 0,5 µm bis 1,0 µm aufweist.

## Revendications

1. Procédé de fabrication d'une tranche épitaxiale (300B), dans lequel le procédé comprend :
la formation d'une couche tampon sur un substrat (110) incluant du carbure de silicium ;
la croissance d'une première couche épitaxiale (212B) ayant une épaisseur de 1 µm ou moins sur la couche tampon à une première température de croissance qui est définie entre 1400° C et 1500° C et à une première vitesse de croissance qui est définie à une vitesse de 5 µm/h ou moins, par injection d'une source de réaction sur le substrat (110) ;
la croissance d'une deuxième couche épitaxiale (214B) à une seconde température de croissance qui est définie dans la plage de 1500° C à 1700° C et à une seconde vitesse de croissance qui est définie à une vitesse de 30 µm/h ou plus, par injection continue de la source de réaction sur le substrat,
le procédé comprenant en outre la croissance d'une troisième couche épitaxiale (216) sur la première couche épitaxiale (212B) par injection continue de la source de réaction après la croissance de la première couche épitaxiale (212B) et avant la croissance de la deuxième couche épitaxiale (214B), à une température de croissance qui change de manière linéaire ou progressivement de la première température de croissance à la deuxième température de croissance,
dans lequel chacun du substrat et de la structure épitaxiale comprend du carbure de silicium.

2. Procédé selon la revendication 1, dans lequel une composition de la première couche épitaxiale est la même que celle de la deuxième couche épitaxiale.

3. Procédé selon l'une quelconque des revendications 1 et 2, dans lequel chacune des première et deuxième couches épitaxiales dopées avec un dopant de type n comprend du carbonitrure de silicium, SiCN.

4. Procédé selon l'une quelconque des revendications 1 et 2, dans lequel chacune des première et deuxième couches épitaxiales dopées avec un dopant de type p comprend du carbure d'aluminium et de silicium, AlSiC.

5. Procédé selon l'une quelconque des revendications 1 à 4, dans lequel la première couche épitaxiale a une épaisseur de 0,5 µm à 1,0 µm.
